# EUROPÄISCHE PATENTSCHRIFT

(11) **EP 1 801 946 B1**
(45) Veröffentlichungstag und Bekanntmachung des Hinweises auf die Patenterteilung: **21.01.2009**
(21) Anmeldenummer: 05028145.0
(22) Anmeldetag: 22.12.2005
(51) Int. Cl.: H02H 3/50, H01J 37/32, H01J 37/34

(54) **Verfahren und Vorrichtung zur Arcerkennung in einem Plasmaprozess**
Method and device of arc detection in a plasma process
Procédé et dispositif de détection d'arc dans un procédé plasma

(43) Veröffentlichungstag der Anmeldung: 27.06.2007
(73) Patentinhaber: HÜTTINGER Elektronik GmbH + Co. KG, 79111 Freiburg (DE)
(72) Erfinder: Axenbeck, Sven, 79395 Neuenburg (DE); Bannwarth, Markus, 79115 Freiburg (DE); Steuber, Martin, 79426 Buggingen (DE); Wiedemuth, Peter, Dr., 79336 Herbolzheim (DE); Wolf, Lothar, 79361 Sasbach (DE)
(74) Vertreter: Schiz, Jochen

(56) Entgegenhaltungen:
- DE-A1- 4 420 951
- US-A- 4 031 464
- US-A- 4 625 283
- US-A- 4 694 402
- US-B1- 6 420 863

## Beschreibung

Die Erfindung betrifft ein Verfahren zur Arcerkennung in einem Plasmaprozess, der von einem Wechselstromgenerator mit einem Ausgangssignal des Wechselstromgenerators zur Leistungszufuhr gespeist wird.

Die Beschichtung von Substraten, z.B. Glasflächen mittels Sputtern/Kathodenzerstäuben in Plasmaprozessen, und zwar sowohl reaktiv als auch konventionell, ist z.B. aus der Architekturglasbeschichtung bekannt. Dazu wird mit einer Strom- oder Spannungsquelle ein Plasma erzeugt, das von einem Target Material abträgt, welches sich auf dem Substrat, z.B. der Glasscheibe, ablagert. Vor der Ablagerung können sich die Atome je nach gewünschter Beschichtung in einem reaktiven Prozess noch mit Gasatomen oder -molekülen verbinden.

Insbesondere bei reaktiven Prozessen werden häufig MF-Generatoren eingesetzt, die üblicherweise bei einer Frequenz von 10 - 500kHz arbeiten. Die Ausgangsspannung von MF-Generatoren wird üblicherweise an zwei Elektroden in einer Plasmaprozesskammer geführt, die wechselseitig als Kathode und Anode arbeiten und die beide mit je einem Target verbunden sind. Es gibt so genannte frei schwingende MF-Generatoren oder als MF-Generatoren mit Festfrequenz.

Insbesondere bei reaktiven Prozessen kommt es auch bei MF-Generatoren zu Überschlägen, die oft mit der nächsten Spannungsumkehr oder zumindest nach wenigen Perioden von selbst verlöschen, zu so genannten Micro-Arcs. Es können aber auch energiereichere und länger andauernde Arcs auftreten. Häufig werden Arcs erkannt durch Überprüfen der Ausgangsspannung auf einen Spannungseinbruch oder durch Überprüfen des Ausgangsstroms auf einen Stromanstieg. Alternativ kann ein Arc an der Differenz zwischen den Strömen zu den einzelnen Elektroden erkannt werden. Ein Grenzwert für die Erkennung von Arcs kann im Stand der Technik vom Betreiber eingestellt werden. Für die Erkennung werden die effektiven Werte von Strom und Spannung gemessen. Da eine solche Messung die Spannungswerte und Stromwerte über die Periode betragsmäßig aufintegrieren muss, um nicht Nulldurchgänge als Spannungsabsenkungen zu erkennen, ist diese Art der Erkennung eines Arcs in der Regel deutlich langsamer als die Dauer einer Halbwelle der MF -Ausgangsspannung und damit länger als 40µs.

Bei der Verwendung der MF - Generatoren im Halbleiterfertigungsprozess, insbesondere in der Flat-Panel-Display FPD - Herstellung, werden aber erhöhte Anforderungen an die Generatoren gestellt. Hier sollen Arcs innerhalb weniger µs oder sogar unterhalb einer µs erkannt werden.

Bei dem aus der DE 43 26 100 A1 bekannten Verfahren zur Arcerkennung ist vorgesehen, dass jeweils eine Halbwelle des Mittelfrequenzsignals des Mittelfrequenzgenerators in eine Vielzahl von Zeitabschnitten unterteilt wird, wobei für einen vorab bestimmten Zeitabschnitt die elektrischen Werte von Strom und Spannung zur Bildung eines Istwertsignals erfasst und in eine erdfreie Messinsel eingegeben werden. Die Messinsel ist in ein ringförmiges Netzwerk eingebunden, dessen Master-Station sich in der im Generator vorhandenen Steuereinheit befindet, wobei die Sperrung des Generators beim Auftreten eines Arcs über eine Verbindungsleitung erfolgt, die die Messinsel mit dem Generator verbindet.

Gemäß der US 6,420,863 B1 ist vorgesehen, Werte wenigstens eines Entladungsstroms oder einer Entladungsspannung für jede Halbwelle zu messen. Eine Differenz wird aus den gemessenen Werten einer ersten und zweiten Halbwelle gebildet. Die Differenz wird mit vorgegebenen Toleranzen verglichen und wenn die Toleranzen überschritten werden, wird die Leistungsversorgung reduziert.

Aufgabe der vorliegenden Erfindung ist es, ein Verfahren zur Arcerkennung und eine Arcerkennungseinrichtung bereitzustellen, mit denen Arcs schneller und zuverlässiger erkannt werden können.

Diese Aufgabe wird erfindungsgemäß auf überraschende und einfache Art und Weise durch ein Verfahren zur Arcerkennung in einem Plasmaprozess gelöst, der von einem Wechselstromgenerator mit einem Ausgangssignal des Wechselstromgenerators zur Leistungszufuhr gespeist wird, umfassend die Verfahrensschritte:
a. Bestimmen eines Zeitpunkts, zu dem als Auswertungssignal das Ausgangssignal oder ein mit dem Ausgangssignal in Beziehung stehendes Signal einen Referenzwert bei positiver Halbwelle des Auswertungssignals überschreitet oder bei negativer Halbwelle des Auswertungssignals unterschreitet, und/oder
b. Bestimmen eines darauf folgenden Zeitpunkts, zu dem das Auswertungssignal in derselben Halbwelle den Referenzwert bei positiver Halbwelle des Auswertungssignals unterschreitet oder bei negativer Halbwelle des Auswertungssignals überschreitet,
c. Bestimmen zumindest eines Zeitintervalls unter Verwendung zumindest eines der Zeitpunkte,
d. Wiederholen der Verfahrensschritte a) - c) für eine spätere Halbwelle des Auswertungssignals,
e. Vergleich der sich entsprechenden Zeitintervalle,
f. Generierung eines Arcerkennungssignals, wenn die sich entsprechenden Zeitintervalle um mehr als eine vorgebbare Toleranz voneinander abweichen.

Mit einem solchen Verfahren können selbst kleinste Arcs sicher und schnell erkannt werden, ohne Spannungsschwankungen, die z. B. durch Druckveränderungen in der Plasmakammer hervorgerufen werden, fälschlicherweise als Arcs zu erkennen. Mit diesem Verfahren kann die Arcerkennung auch besonders schnell erfolgen. Insbesondere können Arcs innerhalb weniger Mikrosekunden beziehungsweise sogar schneller, d.h. unter einer Mikrosekunde, erkannt werden. Auf die Erkennung des Arcs kann entsprechend reagiert werden, so dass Beschädigungen, insbesondere in der Flatpaneldisplay (FPD) - Herstellung, vermieden und Ausschuss reduziert werden können. Als Auswertungssignal kommen beispielsweise der Ausgangsstrom, die Ausgangsspannung oder die Ausgangsleistung des Wechselstromgenerators infrage. Bevorzugt wird die Ausgangsspannung überwacht, bzw. die Spannung, die unmittelbar an den Elektroden anliegt, gemessen und als Auswertungssignal verwendet. Es ist jedoch auch denkbar, ein mit dem Ausgangssignal in Beziehung stehendes internes Signal des Wechselstromgenerators als Auswertungssignal zu verwenden.

Bei einer besonders bevorzugten Verfahrensvariante kann vorgesehen sein, dass die Zeitintervalle für Halbwellen gleicher Polarität bestimmt und verglichen werden. Unterschiedliche Spannungsverläufe entstehen bei unterschiedlichem Abbrennen der Targets in einem Plasmaprozess. Dass hierdurch bewirkte Schwankungen als Arc erkannt werden, kann verhindert werden, wenn Halbwellen gleicher Polarität zur Arcerkennung verwendet werden.

Eine fehlerhafte Reaktion auf Schwankungen des Auswertungssignals kann weiterhin dadurch vermieden werden, dass die Zeitintervalle für unmittelbar aufeinander folgende Halbwellen gleicher Polarität bestimmt und verglichen werden.

Bei einer bevorzugten Verfahrensvariante kann vorgesehen sein, dass die zu vergleichenden Zeitintervalle als Differenz der aufeinander folgenden Zeitpunkte, zu denen der Referenzwert über- bzw. unterschritten werden, gebildet werden und ein Arcerkennungssignal generiert wird, wenn das Zeitintervall der späteren Halbwelle um mehr als die vorgebbare Toleranz kleiner ist als das entsprechende Zeitintervall der früheren Halbwelle. Es wird somit die Zeitspanne zwischen dem Überschreiten des Referenzwerts bei steigender Flanke einer positiven Halbwelle und Unterschreiten des Referenzwerts bei fallender Flanke der positiven Halbwelle ermittelt. Entsprechend wird bei negativer Halbwelle die Zeitspanne zwischen dem Unterschreiten des Referenzwerts bei fallender Flanke und Überschreiten des Referenzwerts bei steigender Flanke ermittelt. Wenn diese Zeitspanne für eine spätere Halbwelle um mehr als eine vorgegebene Toleranz unter der für die frühere Halbwelle ermittelten Zeitspanne liegt, ist dies ein Indiz für das Vorhandensein eines Arcs. Die Gesamttoleranz kann sich dabei aus zwei unterschiedlichen Toleranzwerten am Anfang und Ende der Zeitspanne bzw. des Zeitintervalls zusammensetzen.

Bei einer weiteren Verfahrensvariante kann vorgesehen sein, dass der Zeitpunkt des Nulldurchgangs des Auswertungssignals zu Beginn der Halbwelle erfasst wird, die zu vergleichenden Zeitintervalle als Differenz zwischen dem Zeitpunkt eines ungeradzahligen (ersten, dritten, etc.) Über- bzw. Unterschreitens (Passieren) des Referenzwerts und dem Zeitpunkt des Nulldurchgangs gebildet werden und ein Arcerkennungssignal generiert wird, wenn das Zeitintervall der späteren Halbwelle um mehr als die vorgebbare Toleranz größer ist als das Zeitintervall der früheren Halbwelle. Diese Verfahrensvariante kann besonders einfach in einem programmierbaren Logikbaustein implementiert werden.

Alternativ oder zusätzlich ist es denkbar, dass der Zeitpunkt des Nulldurchgangs des Auswertungssignals zu Beginn der Halbwelle erfasst wird, die zu vergleichenden Zeitintervalle als Differenz zwischen dem Zeitpunkt eines geradzahligen (zweiten, vierten etc.) Über- bzw. Unterschreitens (Passieren) des Referenzwerts und dem Zeitpunkt des Nulldurchgangs gebildet werden und ein Arcerkennungssignal generiert wird, wenn das Zeitintervall der späteren Halbwelle um mehr als die vorgebbare Toleranz kleiner ist, als das Zeitintervall der früheren Halbwelle.

Die Zuverlässigkeit der Arcerkennung kann erhöht werden, wenn ein Zeitintervall für die Arcerkennung unberücksichtigt bleibt, wenn das Zeitintervall, das sich als Differenz zwischen dem Zeitpunkt des Über- bzw. Unterschreitens des Referenzwerts und dem darauf folgenden Unter- bzw. Überschreiten des Referenzwerts ergibt, unter einer vorgebbaren Zeitdauer liegt. Schwankungen des Auswertungssignals, die nicht auf einen Arc zurückzuführen sind, bleiben daher unberücksichtigt.

Wenn mehrere Referenzwerte vorgegeben werden, können Arcs mit einer höheren Genauigkeit und schneller erkannt werden.

Bei einer besonders bevorzugten Verfahrensvariante kann vorgesehen sein, dass ein über mehrere Halbwellen gemittelter Amplitudenmittelwert gebildet wird und der oder die Referenzwerte in Abhängigkeit von dem Amplitudenmittelwert vorgegeben werden. Durch diese Maßnahme sind die Referenzwerte nicht starr vorgegeben, sondern können die Referenzwerte automatisch an ein sich möglicherweise im Betrieb graduell veränderndes Auswertungssignal angepasst werden. Vorzugsweise werden die Referenzwerte in Prozent des Amplitudenmittelwerts, beispielsweise 20, 40, 60, 80% des Amplitudenmittelwerts, gewählt.

In den Rahmen der Erfindung fällt außerdem eine Arcerkennungseinrichtung zur Arcerkennung in einem Plasmaprozess, ausgelegt zur Durchführung des erfindungsgemäßen Verfahrens, mit zumindest einem Analog-Digital Wandler (ADC), dem als Auswertungssignal das Ausgangssignal oder ein mit dem Ausgangssignal in Beziehung stehendes internes Signal eines Wechselstromgenerators und ein Referenzwert zugeführt sind, wobei der ADC mit einem Logikbaustein in Verbindung steht, der ein Signal für eine Arcunterdrückungseinrichtung generiert. Der Vorteil der erfindungsgemäßen Arcerkennungseinrichtung liegt darin, dass der Logikbaustein anhand des ADC-Signals unmittelbar, ohne Zwischenschaltung einer Steuereinrichtung, das Arcerkennungssignal generieren kann. Dies ist bedeutend schneller, als dies durch eine Steuereinrichtung, beispielsweise einen Microcontroller, möglich wäre. Vorzugsweise handelt es sich bei dem Logikbaustein um einen programmierbaren Logikbaustein. Im einfachsten Fall besteht der ADC aus einem Komparator.

Eine besonders einfache Implementierung des erfindungsgemäßen Verfahrens ergibt sich, wenn der Logikbaustein als FPGA ausgebildet ist.

Bei einer vorteilhaften Ausführungsform kann ein Controller vorgesehen sein, der dem Logikbaustein (Parameter-)Werte vorgibt. Somit können unterschiedliche Parameterwerte, wie beispielsweise Toleranzwerte oder die Länge von Zeitintervallen, die für die Arcerkennung nicht berücksichtigt werden, vorgegeben werden.

Je nach Prozess kann es notwendig sein, unterschiedliche Toleranzwerte vorzugeben. Um dies einem Benutzer zu ermöglichen, können vorteilhafterweise, dem Controller ein Bedienfeld und eine Anzeige zugeordnet sein.

Eine besonders schnelle und genaue Arcerkennung kann realisiert werden, wenn mehrere, insbesondere vier, Komparatoren vorgesehen sind, denen unterschiedliche Referenzwerte zugeführt sind. Diese Komparatoren sind alle mit dem programmierbaren Logikbaustein verbunden.

Vorteilhafterweise ist eine Referenzwerterzeugungseinrichtung, insbesondere ein Spannungsteiler, vorgesehen. Dem Spannungsteiler kann ein gemittelter Amplitudenmittelwert des Auswertungssignals zugeführt sein. Zwischen den Widerständen des Spannungsteilers können durch die Komparatoren die Referenzwerte abgegriffen werden. Durch die Anzahl und Dimensionierung der Widerstände können die Referenzwerte, insbesondere in Prozent des Amplitudenmittelwerts, eingestellt werden.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug zu den Figuren der Zeichnung näher erläutert. Es zeigt:
- **Fig. 1**: alle schematische Darstellung einer Arc-Erkennungseinrichtung;
- **Fig. 2**: die Darstellung zweier Halbwellen zur Verdeutlichung des erfindungsgemäßen Verfahrens.

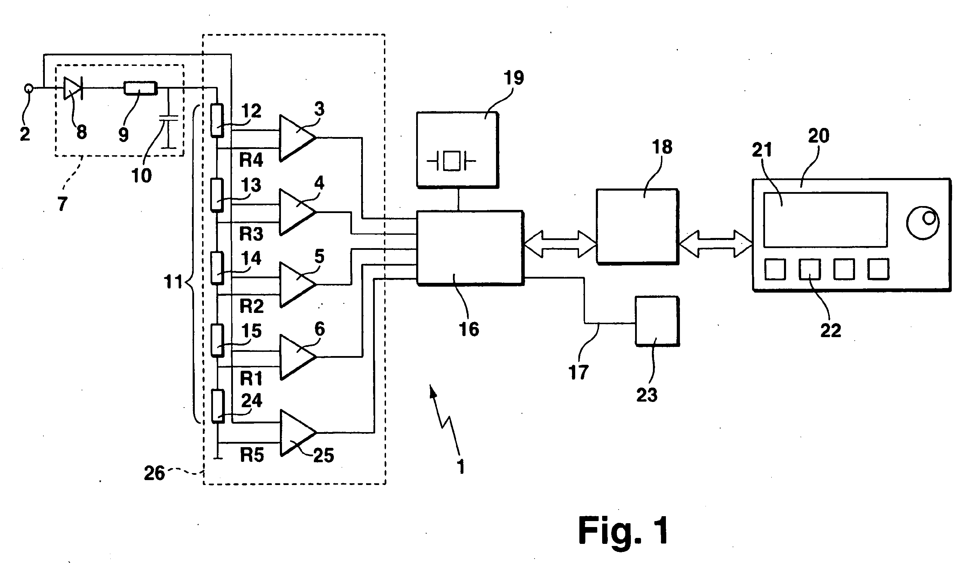

In der Figur 1 ist eine Arcerkennungseinrichtung 1 dargestellt. An dem Eingang 2 liegt ein Auswertungssignal an, welches von einem Wechselstromgenerator oder von einer Messung unmittelbar an den Elektroden der Plasmaprozesskammer stammt. Bei dem Auswertungssignal kann es sich beispielsweise um die von dem Wechselspannungsgenerator generierte Wechselspannung oder um ein internes Signal des Wechselspannungsgenerators handeln. Im Ausführungsbeispiel wird dieses Signal auf jeweils einen Eingang der als Komparatoren ausgebildeten Analog-Digital-Wandler (ADC) 3, 4, 5, 6, 25 gegeben. Das Auswertungssignal wird außerdem an einen Spitzenwertgleichrichter 7 gegeben, wobei der Spitzenwertgleichrichter 7 eine Diode 8, einen Widerstand 9 und ein Kondensator 10 umfasst. Im Spitzenwert Gleichrichter 7 wird eine über mehrere Perioden des Auswertungssignals gemittelte Amplitude UA bestimmt. Im Ausführungsbeispiel wird eine Spannung bestimmt. Diese liegt an der als Spannungsteiler ausgebildeten Referenzwerterzeugungseinrichtung 11 an. Die Widerstände 12, 13, 14, 15 der Referenzwerterzeugungseinrichtung 11 sind alle gleich dimensioniert. Dies bedeutet, dass an allen Widerständen dieselbe Spannung abfällt, so dass die gemittelte Amplitude in vier gleich große Spannungen unterteilt wird. Diese werden als Referenzwerte R1, R2, R3, R4 den ADCs 3 - 6 zugeführt und dort mit dem aktuellen Auswertungssignal verglichen. Das Vergleichsergebnis wird einem programmierbaren Logikbaustein 16 zugeführt, der aus den Informationen der ADCs 3 - 6 ermittelt, ob ein Arc vorliegt oder nicht.

Der Komparator 25 erkennt den Nulldurchgang, indem der Referenzwert R5 mit dem Auswertungssignal verglichen wird. Die Schaltungsanordnung 26 umfasst die ADCs 3-6,25 und die Referenzwerterzeugungseinrichtung 11. Sie kann auch durch einen ADC realisiert werden. Das reduziert die Bauteilkosten. Außerdem können die Referenzwerte, insbesondere Referenzspannungsschwellen, noch feiner eingestellt werden. Zudem kann man einen ADC für die positive und negative Halbwelle einsetzen und so weiter Bauteile, Kosten und Platz sparen. Zusätzlich kann ein ADC für die Messung des Stroms, der in den Plasmaprozess fließt, vorgesehen werden. Dann können Strom und Spannung überwacht werden.

Liegt ein Arc vor, wird ein entsprechendes Signal über die Leitung 17 unmittelbar, ohne einen Mikrocontroller 18 oder ein Steuergerät 20 zwischenzuschalten, ausgegeben. Die Leitung 17 geht unmittelbar an eine Arcunterdrückungs- oder Arclöscheinrichtung 23. Der programmierbare Logikbaustein 16 ist mit einem Mikrocontroller 18 verbunden, über den unterschiedliche Parameterwerte vorgegeben werden können. Weiterhin ist der programmierbare Logikbaustein 16 mit einem Taktgeber 19 verbunden, der die schnelle Informationsverarbeitung in dem programmierbaren Logikbaustein 16 ermöglicht.

Der Mikrocontroller steht wiederum mit dem übergeordneten Steuergerät 20 in Datenaustauschverbindung. Das Steuergerät 20 weist eine Anzeige 21 und ein Bedienfeld 22 auf, so dass der Mikrocontroller 18 und damit der Logikbaustein 16 programmiert werden können.

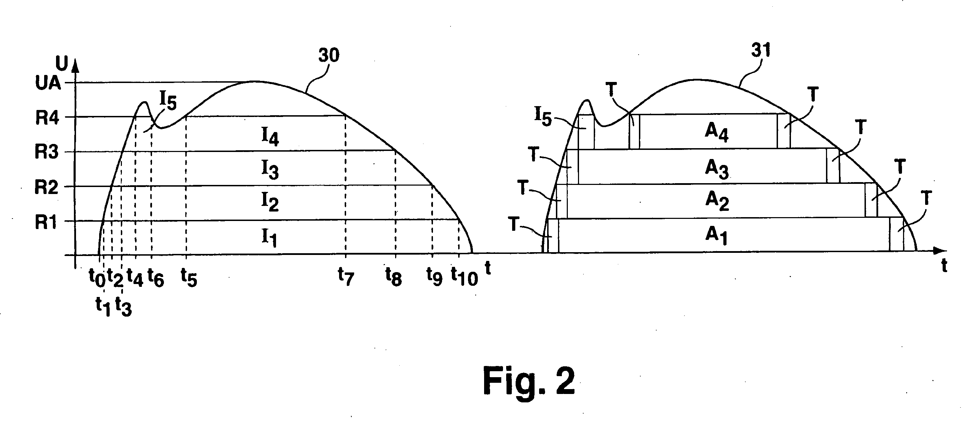

In der Figur 2 sind eine erste und eine spätere positive Halbwelle 30, 31 eines Auswertungssignals, in diesem Fall der Ausgangsspannung eines MF-Generators, dargestellt. Gemäß dem erfindungsgemäßen Verfahren wird der Zeitpunkt t1 erfasst, zu dem das steigende Auswertungssignal den Referenzwert R1 übersteigt. Gleichermaßen werden die Zeitpunkte t2 - t5 erfasst, zu denen das ansteigende Auswertungssignal mit der positiven Halbwelle 30 die Referenzwerte R2, R3, R4 übersteigt. Weiterhin werden die Zeitpunkte t6, t7, t8, t9, t10 erfasst, zu denen das abfallende Auswertungssignal die Referenzwerte R1 - R4 unterschreitet. Hierbei ist zu beachten, dass zum Zeitpunkt t4 der Referenzwert R4 zum ersten Mal und zum Zeitpunkt t5 zum zweiten Mal überschritten wird, und dass dem Zeitpunkt t6 der Referenzwert R4 zum ersten Mal und zum Zeitpunkt t7 zum zweiten Mal unterschritten wird.

Unter Berücksichtigung zumindest einiger der Zeitpunkte t1 - t10 und möglicherweise des Zeitpunkt t0 des Nulldurchgangs werden Zeitintervalle für jeden Referenzwert R1 - R4 gebildet. Insbesondere können Zeitintervalle gebildet werden, indem die Zeitpunkte t10 und t1, t9 und t2, t8 und t3, t7 und t5 sowie t6 und t4 voneinander subtrahiert werden. Diese Intervalle sind mit I1- I5 gekennzeichnet. Alternativ oder zusätzlich können Zeitintervalle bestimmt werden, die sich aus der Differenz der Zeitpunkte t1 - t10 zum Zeitpunkt t0 des Nulldurchgangs ergeben.

Jedem so ermittelten Zeitintervall kann eine Toleranz zugeordnet werden. Dabei können für alle Referenzwerte die gleichen Toleranzen oder jeweils unterschiedliche Toleranzen vorgegeben werden. Die Toleranzen können über das Steuergerät 20 eingestellt werden. Der Mikrocontroller 18 speichert die eingestellten Werte und gibt sie an den Logikbaustein 16 weiter. Die Toleranzen können als feste Zeitwerte oder als Teile einer Halbwelle oder als Teil eines Intervalls I1-I4 angegeben werden. Vorteilhaft ist die Angabe in Prozent der Dauer der Halbwelle, weil die Angabe dann bei sich verändernder Frequenz nicht neu eingegeben werden muss. Typische Werte für die Toleranzen liegen bei 10-20% der Dauer der Halbwelle für I1 bis I3 und 20 - 35% für I4. Weiterhin ist es denkbar, unterschiedliche Toleranzwerte für den Beginn und das Ende eines Zeitintervalls vorzugeben. Dies ist für die zweite Halbwelle 31 dargestellt. In diesem Fall wurde für alle Referenzwerte der gleiche erste Toleranzwert für den Beginn und der gleiche zweite Toleranzwert, der größer ist als der erste Toleranzwert, für das Ende der Zeitintervalle I1 - I5 vorgegeben. Die Toleranzwerte sind mit T angedeutet. Solange sich die Halbwelle 31 in diesen mit T markierten Stellen oder außerhalb davon bewegt, erfolgt keine Arcerkennung. Sobald sich jedoch die Halbwelle 31 in einem der Bereiche A1 - A4 bewegt, erfolgt eine Arcerkennung.

Bezüglich des Zeitintervalls 15 ist festzustellen, dass die Länge dieses Intervall geringer ist als eine vorgebbare minimale Zeitdauer. Deshalb bleibt dieses Zeitintervall I5 für eine Arcerkennung unberücksichtigt. Die minimale Zeitdauer kann über das Steuergerät 20 eingestellt werden. Der Micro-controller 18 speichert den eingestellten Wert und gibt ihn an den Logikbaustein 16 weiter. Die Zeitdauer kann als fester Zeitwert oder als ein Teil einer Halbwelle angegeben werden. Vorteilhaft ist die Angabe in Prozent der Dauer der Halbwelle, weil die Angabe dann bei sich verändernder Frequenz nicht neu eingegeben werden muss. Typische Werte liegen bei 10-20% der Dauer der Halbwelle bei I1 bis I3, und 5-15% bei I4.

Wie vorher bereits erwähnt, ist es möglich, alternativ oder zusätzlich zur Bildung der Zeitintervalle I1 - I4 bzw. der um die Toleranzwerte verkürzten Zeitintervalle A1 - A4 die Differenz zwischen den Zeitpunkten t1 - t10 und dem Zeitpunkt t0 des Nulldurchgangs zu ermitteln. Dabei kann ein erster Toleranzwert für die Zeitpunkte t1 - t5 bei steigender Halbwelle 30 (der gleiche für alle Referenzwerte oder für einen oder mehrere, insbesondere für jeden Referenzwert unterschiedliche) vorgegeben werden. Wird dieser Toleranzwert überschritten, beispielsweise weil das Zeitintervall t1-t0 der Halbwelle 31 um mehr als den vorgegebenen Toleranzwert größer ist als das Zeitintervall t1 - t0 der Halbwelle 30, wird ein Arc erkannt. Damit die richtigen Zeitpunkte zur Bewertung verwendet werden, muss hier beachtet werden, dass es sich bei den Zeitpunkten t1, t2, t3, t4 um das erste Über- bzw. Unterschreiten des jeweiligen Referenzwerts pro Halbwelle und bei dem Zeitpunkt t5 um das dritte Passieren des Referenzwerts R4 handelt. Für diese Analyse müssen also die Zeitpunkte des ungeradzahligen Passierens des jeweiligen Referenzwerts verwendet werden.

Ebenso wird ein Arc erkannt, wenn die mit den Zeitpunkten t6 - t10 der fallenden Flanke der Halbwelle 30 gebildeten Zeitintervalle berücksichtigt werden. Dabei kann ein zweiter Toleranzwert für die Zeitpunkte t6 - t10 bei fallender Halbwelle 30 (der gleiche für alle Referenzwerte oder für einen oder mehrere, insbesondere für jeden Referenzwert unterschiedliche) vorgegeben werden. Wird dieser Toleranzwert unterschritten, beispielsweise weil das Zeitintervall t10-t0 der Halbwelle 31 um mehr als den vorgegebenen Toleranzwert kleiner ist als das Zeitintervall t10 - t0 der Halbwelle 30, wird ein Arc erkannt. Damit die richtigen Zeitpunkte zur Bewertung verwendet werden, muss hier beachtet werden, dass es sich bei den Zeitpunkten t6, t8, t9, t10 um das zweite Über- bzw. Unterschreiten des jeweiligen Referenzwerts pro Halbwelle und bei dem Zeitpunkt t7 um das vierte Passieren des Referenzwerts R4 handelt. Für diese Analyse müssen also die Zeitpunkte des geradzahligen Passierens des jeweiligen Referenzwerts verwendet werden.

Es versteht sich, dass gleichzeitig mit der Überprüfung, ob die zweite Halbwelle 31 eine Form aufweist, die für einen Arc spricht, wiederum die Zeitpunkte t0 - t10 für diese Halbwelle erfasst werden können, so dass diese Halbwelle wieder mit der nächsten Halbwelle verglichen werden kann.

## Patentansprüche

1. Verfahren zur Arcerkennung in einem Plasmaprozess, der von einem Wechselstromgenerator mit einem Ausgangssignal des Wechselstromgenerators zur Leistungszufuhr gespeist wird, umfassend die Verfahrensschritte:
a. Bestimmen eines Zeitpunkts (t1 - t5), zu dem als Auswertungssignal das Ausgangssignal oder ein mit dem Ausgangssignal in Beziehung stehendes Signal einen Referenzwert (R1 - R4) bei positiver Halbwelle (30) des Auswertungssignals überschreitet oder bei negativer Halbwelle des Auswertungssignals unterschreitet, und/oder
b. Bestimmen eines darauf folgenden Zeitpunkts (t6 - t10), zu dem das Auswertungssignal in derselben Halbwelle (30) den Referenzwert (R1 - R4) bei positiver Halbwelle (30) des Auswertungssignals unterschreitet oder bei negativer Halbwelle des Auswertungssignals überschreitet,
c. Bestimmen zumindest eines Zeitintervalls (I1 - I5) unter Verwendung zumindest eines der Zeitpunkte (t1 - t10),
d. Wiederholen der Verfahrensschritte a) - c) für eine spätere Halbwelle (31) des Auswertungssignals,
e. Vergleich der sich entsprechenden Zeitintervalle (I1 - I5),
f. Generierung eines Arcerkennungssignals, wenn die sich entsprechenden Zeitintervalle (I1 - I5) um mehr als eine vorgebbare Toleranz (T) voneinander abweichen.

2. Verfahren nach Anspruch 1, **dadurch gekennzeichnet, dass** die Zeitintervalle(I1 - I5) für Halbwellen (30, 31) gleicher Polarität bestimmt und verglichen werden.

3. Verfahren nach Anspruch 2, **dadurch gekennzeichnet, dass** die Zeitintervalle für unmittelbar aufeinander folgende Halbwellen (30, 31) gleicher Polarität bestimmt und verglichen werden.

4. Verfahren nach einem der vorhergehenden Ansprüche, **dadurch gekennzeichnet, dass** die zu vergleichenden Zeitintervalle (I1 - I5) als Differenz der aufeinander folgenden Zeitpunkte (t1 - t10), zu denen der Referenzwert (R1 - R4) über- bzw. unterschritten werden, gebildet werden und ein Arcerkennungssignal generiert wird, wenn das Zeitintervall (I1 - I5) der späteren Halbwelle (31) um mehr als die vorgebbare Toleranz (T) kleiner ist als das entsprechende Zeitintervall (I1 - I5) der früheren Halbwelle (30).

5. Verfahren nach einem der vorhergehenden Ansprüche, **dadurch gekennzeichnet, dass** der Zeitpunkt (t0) des Nulldurchgangs des Auswertungssignals zu Beginn der Halbwelle (30, 31) erfasst wird, die zu vergleichenden Zeitintervalle als Differenz zwischen dem Zeitpunkt (t1 - t5) eines ungeradzahligen (ersten, dritten, etc.) Über- bzw. Unterschreitens des Referenzwerts (R1 - R4) und dem Zeitpunkt (t0) des Nulldurchgangs gebildet werden und ein Arcerkennungssignal generiert wird, wenn das Zeitintervall der späteren Halbwelle (31) um mehr als die vorgebbare Toleranz (T) größer ist als das Zeitintervall der früheren Halbwelle (30).

6. Verfahren nach einem der vorhergehenden Ansprüche, **dadurch gekennzeichnet, dass** der Zeitpunkt (t0) des Nulldurchgangs des Auswertungssignals zu Beginn der Halbwelle (30, 31) erfasst wird, die zu vergleichenden Zeitintervalle als Differenz zwischen dem Zeitpunkt (t6 - t10) eines geradzahligen (zweiten, vierten etc.) Über- bzw. Unterschreitens des Referenzwerts und dem Zeitpunkt (t0) des Nulldurchgangs gebildet werden und ein Arcerkennungssignal generiert wird, wenn das Zeitintervall der späteren Halbwelle (31) um mehr als die vorgebbare Toleranz (T) kleiner ist als das Zeitintervall der früheren Halbwelle (30).

7. Verfahren nach einem der vorhergehenden Ansprüche, **dadurch gekennzeichnet, dass** ein Zeitintervall (15) für die Arcerkennung unberücksichtigt bleibt, wenn das Zeitintervall (I5), das sich als Differenz zwischen dem Zeitpunkt (t1 - t5) des Über- bzw. Unterschreitens des Referenzwerts (R1 - R4) und dem Zeitpunkt (t6 - t10) des darauf folgenden Unter- bzw. Überschreiten des Referenzwerts (R1 - R4) ergibt, unter einer vorgebbaren Zeitdauer liegt.

8. Verfahren nach einem der vorhergehenden Ansprüche, **dadurch gekennzeichnet, dass** mehrere Referenzwerte (R1 - R4) vorgegeben werden.

9. Verfahren nach einem der vorhergehenden Ansprüche, **dadurch gekennzeichnet, dass** ein über mehrere Halbwellen (30, 31) gemittelter Amplitudenmittelwert (UA) gebildet wird und der oder die Referenzwerte (R1 - R4) in Abhängigkeit von dem Amplitudenmittelwert (UA) vorgegeben werden.

10. Arcerkennungseinrichtung (1) zur Arcerkennung in einem Plasmaprozess, ausgelegt zur Durchführung des Verfahrens nach einem der vorhergehenden Ansprüche, mit zumindest einem Analog-Digital-Wandler (ADC), insbesondere einem Komparator (3 - 6), dem als Auswertungssignal das Ausgangssignal oder ein mit dem Ausgangssignal in Beziehung stehendes internes Signal eines Wechselstromgenerators und ein Referenzwert (R1 - R4) zugeführt sind, wobei der ADC (3 - 6) mit einem Logikbaustein (16) in Verbindung steht, der unmittelbar ein Signal für eine Arcunterdrückungseinrichtung (23) generiert.

11. Arcerkennungseinrichtung nach Anspruch 10, **dadurch gekennzeichnet, dass** ein Controller (18) vorgesehen ist, der dem Logikbaustein (16) (Parameter-)Werte vorgibt.

12. Arcerkennungseinrichtung nach einem der vorhergehenden Ansprüche 10 oder 11, **dadurch gekennzeichnet, dass** dem Controller (18) ein Bedienfeld (22) und eine Anzeige (21) zugeordnet sind.

13. Arcerkennungseinrichtung nach einem der vorhergehenden Ansprüche 10 - 12, **dadurch gekennzeichnet, dass** mehrere, insbesondere vier, Komparatoren (3 - 6) vorgesehen sind, denen unterschiedliche Referenzwerte (R1 - R4) zugeführt sind.

14. Arcerkennungseinrichtung nach einem der Ansprüche 10 - 13, **dadurch gekennzeichnet, dass** eine Referenzwerterzeugungseinrichtung (11), insbesondere ein Spannungsteiler, vorgesehen ist.

15. Arcerkennungseinrichtung nach einem der vorhergehenden Ansprüche 10 - 14, **dadurch gekennzeichnet, dass** der Logikbaustein (16) Zeitintervalle ermittelt und diese in einem Zwischenspeicher ablegt.

16. Arcerkennungseinrichtung nach einem der vorhergehenden Ansprüche 10 - 15, **dadurch gekennzeichnet, dass** der Logikbaustein (16) mit einem Taktgeber (19) verbunden ist, der dem Logikbaustein (16) ein Taktsignal zuführt.

17. Arcerkennungseinrichtung nach einem der vorhergehenden Ansprüche 10 - 16, **dadurch gekennzeichnet, dass** ein Spitzenwertgleichrichter (7) vorgesehen ist.

## Claims

1. Method for detecting an arc in a plasma process which is fed by an AC generator with an output signal of the AC generator for power supply, comprising the method steps:
a. determining a time (t1-t5) at which, as an evaluation signal, the output signal or a signal related to the output signal, exceeds a reference value (R1-R4) in a positive half-wave (30) of the evaluation signal, or falls below it in a negative half-wave of the evaluation signal, and/or
b. determining a subsequent time (t6-t10) at which the evaluation signal falls below the reference value (R1-R4) in the same half-wave (30) in a positive half-wave (30) of the evaluation signal, or exceeds it in a negative half-wave of the evaluation signal,
c. determining at least one time interval (I1-I5) using at least one of the times (t1-t10),
d. repeating method steps a) - c) for a later half-wave (31) of the evaluation signal,
e. comparing the mutually corresponding time intervals (I1-I5),
f. generating an arc detection signal, when the mutually corresponding time intervals (I1-I5) differ from each other by more than a predeterminable tolerance (T).

2. Method according to claim 1, **characterized in that** the time intervals (I1 to I5) for half-waves (30, 31) of the same polarity are determined and compared.

3. Method according to claim 2, **characterized in that** the time intervals for directly successive half-waves (30, 31) of the same polarity are determined and compared.

4. Method according to any one of the preceding claims, **characterized in that** the time intervals (I1 to I5) to be compared are formed as the difference between the successive times (t1 to t10) at which the reference value (R1 to R4) is exceeded or fallen below, and an arc detection signal is generated when the time interval (I1 to I5) of the later half-wave (31) is smaller than the corresponding time interval (I1 to I5) of the previous half-wave (30) by more than the predeterminable tolerance (T).

5. Method according to any one of the preceding claims, **characterized in that** the time (t0) of zero crossing of the evaluation signal is detected at the beginning of the half-wave (30, 31), the time intervals to be compared are formed as the difference between the time (t1 to t5) of an odd (first, third, etc.) exceeding or falling below of the reference value (R1 to R4) and the time (t0) of zero crossing, and an arc detection signal is generated when the time interval of the later half-wave (31) is larger than the time interval of the previous half-wave (30) by more than the predeterminable tolerance (T).

6. Method according to any one of the preceding claims, **characterized in that** the time (t0) of zero crossing of the evaluation signal is detected at the beginning of the half-wave (30, 31), the time intervals to be compared are formed as the difference between the time (t6 to t10) of an even (second, fourth et.) exceeding or falling below of the reference value and the time (t0) of zero crossing, and an arc detection signal is generated when the time interval of the later half-wave (31) is smaller than the time interval of the previous half-wave (30) by more than the predeterminable tolerance (T).

7. Method according to any one of the preceding claims, **characterized in that** a time interval (I5) is not taken into consideration for detecting an arc when the time interval (I5), which results as the difference between the time (t1 to t5) at which the reference value (R1 to R4) is exceeded or fallen below and the subsequent time (t6 to t10) at which the reference value (R1 to R4) is fallen below or exceeded, is below a predeterminable time.

8. Method according to any one of the preceding claims, **characterized in that** several reference values (R1 to R4) are predetermined.

9. Method according to any one of the preceding claims, **characterized in that** an average amplitude value (UA) which has been averaged over several half-waves (30, 31) is formed and the reference value(s) (R1 to R4) is/are predetermined in dependence on the average amplitude value (UA).

10. Arc detection means (1) for detecting arcs in a plasma process, designed for performing the method according to any of the preceding claims, comprising at least one analog digital converter (ADC), in particular, a comparator (3 to 6), to which, as an evaluation signal, the output signal or an internal signal of an AC generator related to the output signal, and a reference value (R1 to R4) are supplied, wherein the ADC (3 to 6) is connected to a logic component (16) which directly generates a signal for an arc suppression device (23).

11. Arc detection means according to claim 10, **characterized in that** a controller (18) is provided which presets the (parameter) values of the logic component (16).

12. Arc detection means according to claim 10 or 11, **characterized in that**, an operating field (22) and a display (21) are associated with the controller (18).

13. Arc detection means according any one of the preceding claims 10 through 12, **characterized in that** several, in particular four, comparators (3 - 6) which are fed with different reference values (R1 - R4) are provided.

14. Arc detection means according any one of the preceding claims 10 through 13, **characterized in that** a reference value generating means (11), in particular, a voltage divider, is provided.

15. Arc detection means according any one of the preceding claims 10 through 14, **characterized in that** the logic component (16) determines time intervals and stores the time intervals in a buffer.

16. Arc detection means according any one of the preceding claims 10 through 15, **characterized in that** the logic component (16) is connected to a clock generator (19) which supplies the logic component (16) with a clock signal.

17. Arc detection means according any one of the preceding claims 10 through 16, **characterized in that** a peak value rectifier (7) is provided.

## Revendications

1. Procédé de détection d'arc dans un procédé plasma qui est alimenté par un générateur de courant alternatif avec un signal de sortie du générateur de courant alternatif pour l'amenée de puissance, comprenant les étapes suivantes :
a. détermination d'un instant (t1 - t5) auquel, en tant que signal d'évaluation, le signal de sortie ou un signal en relation avec le signal de sortie dépasse une valeur de référence (R1 - R4) lors de la demi-onde positive (30) du signal d'évaluation ou sous-passe celle-ci lors de la demi-onde négative du signal d'évaluation et/ou
b. détermination d'un instant suivant (t6 - t10) auquel le signal d'évaluation, dans la même demi-onde (30), sous-passe une valeur de référence (R1 - R4) lors de la demi-onde positive (30) du signal d'évaluation ou dépasse celle-ci lors de la demi-onde négative du signal d'évaluation,
c. détermination d'au moins un intervalle de temps (I1 - I5) en utilisant au moins un des instants (t1 - t10),
d. répétition des étapes de procédé a) - c) pour une demi-onde ultérieure (31) du signal d'évaluation,
e. comparaison des intervalles de temps (I1 - I5) se correspondant,
f. génération d'un signal de détection d'arc si les intervalles de temps (I1 - I5) se correspondant différent l'un de l'autre de plus d'une tolérance (T) prescriptible.

2. Procédé selon la revendication 1, **caractérisé en ce que** les intervalles de temps (I1 - I5) sont déterminés et comparés pour des demi-ondes (30, 31) de même polarité.

3. Procédé selon la revendication 2, **caractérisé en ce que** les intervalles de temps sont déterminés et comparés pour des demi-ondes (30, 31) de même polarité immédiatement successives.

4. Procédé selon l'une des revendications précédentes, **caractérisé en ce que** les intervalles de temps (I1 - I5) à comparer sont formés comme différence des instants (t1 - t10) successifs auxquels la valeur de référence (R1 - R4) est dépassée ou sous-passée et un signal de détection d'arc est généré si l'intervalle de temps (I1 - I5) de la demi-onde ultérieure (31) est plus petit de plus de la tolérance (T) prescriptible que l'intervalle de temps (I1 - I5) correspondant de la demi-onde antérieure (30).

5. Procédé selon l'une des revendications précédentes, **caractérisé en ce que** l'instant (t0) du passage par zéro du signal d'évaluation au début de la demi-onde (30, 31) est saisi, que les intervalles de temps à comparer sont formés comme différence entre l'instant (t1 - t5) d'un dépassement ou sous-passement impair (premier, troisième, etc.) de la valeur de référence (R1 - R4) et l'instant (t0) du passage par zéro et qu'un signal de détection d'arc est généré si l'intervalle de temps de la demi-onde ultérieure (31) est plus grand de plus de la tolérance (T) prescriptible que l'intervalle de temps de la demi-onde antérieure (30).

6. Procédé selon l'une des revendications précédentes, **caractérisé en ce que** l'instant (t0) du passage par zéro du signal d'évaluation au début de la demi-onde (30, 31) est saisi, que les intervalles de temps à comparer sont formés comme différence entre l'instant (t6 - t10) d'un dépassement ou sous-passement pair (deuxième, quatrième, etc.) de la valeur de référence et l'instant (t0) du passage par zéro et qu'un signal de détection d'arc est généré si l'intervalle de temps de la demi-onde ultérieure (31) est plus petit de plus de la tolérance (T) prescriptible que l'intervalle de temps de la demi-onde antérieure (30).

7. Procédé selon l'une des revendications précédentes, **caractérisé en ce qu'**un intervalle de temps (I5) est ignoré pour la détection d'arc si l'intervalle de temps (I5) qui est obtenu à partir de la différence entre l'instant (t1 - t5) du dépassement ou sous-passement de la valeur de référence (R1 - R4) et l'instant (t6 - t10) du dépassement ou sous-passement suivant de la valeur de référence (R1 - R4) est inférieur à une durée prescriptible.

8. Procédé selon l'une des revendications précédentes, **caractérisé en ce que** plusieurs valeurs de référence (R1 - R4) sont prescrites.

9. Procédé selon l'une des revendications précédentes, **caractérisé en ce qu'**une valeur moyenne d'amplitude (UA) calculée sur plusieurs demi-ondes (30, 31) est formée et que la ou les valeurs de référence (R1 - R4) sont prescrites en fonction de la valeur moyenne d'amplitude (UA).

10. Dispositif de détection d'arc (1) pour la détection d'arc dans un procédé plasma, conçu pour réaliser le procédé selon l'une des revendications précédentes, avec au moins un convertisseur analogique-numérique (ADC), en particulier un comparateur (3 - 6) auquel sont amenés en tant que signal d'évaluation le signal de sortie ou un signal interne en relation avec le signal de sortie d'un générateur de courant alternatif et une valeur de référence (R1 - R4), l'ADC (3 - 6) étant en liaison avec un composant logique (16) qui génère directement un signal pour un dispositif de suppression d'arc (23).

11. Dispositif de détection d'arc selon la revendication 10, **caractérisé en ce qu'**il est prévu un contrôleur (18) qui prescrit des valeurs (de paramètre) au composant logique (16).

12. Dispositif de détection d'arc selon l'une des revendications 10 ou 11 précédentes, **caractérisé en ce qu'**un panneau de commande (22) et un afficheur (21) sont associés au contrôleur (18).

13. Dispositif de détection d'arc selon l'une des revendications 10 à 12 précédentes, **caractérisé en ce que** plusieurs, en particulier quatre comparateurs (3 - 6) sont prévus, auxquels sont amenés différentes valeurs de référence (R1 - R4).

14. Dispositif de détection d'arc selon l'une des revendications 10 à 13, **caractérisé en ce qu'**un dispositif de génération de valeurs de référence (11), en particulier un diviseur de tension, est prévu.

15. Dispositif de détection d'arc selon l'une des revendications 10 à 14 précédentes, **caractérisé en ce que** le composant logique (16) détermine des intervalles de temps et les enregistre dans une mémoire intermédiaire.

16. Dispositif de détection d'arc selon l'une des revendications 10 à 15 précédentes, **caractérisé en ce que** le composant logique (16) est relié à un générateur d'horloge (19) qui amène un signal d'horloge au composant logique (16).

17. Dispositif de détection d'arc selon l'une des revendications 10 à 16 précédentes, **caractérisé en ce qu'**un redresseur de valeurs de crête (7) est prévu.
